# EUROPÄISCHE PATENTSCHRIFT

(11) **EP 0 285 923 B1**
(45) Veröffentlichungstag und Bekanntmachung des Hinweises auf die Patenterteilung: **06.10.1993**
(21) Anmeldenummer: 88104786.4
(22) Anmeldetag: 25.03.1988
(51) Int. Cl.: H01L 29/08, H01L 29/74, H01L 29/36, H01L 21/225

(54) **Gate-Ausschaltthyristor und Verfahren zu dessen Herstellung**
Gate turn-off thyristor and method of making the same
Thyristor à commande d'extinction et méthode de fabrication

(30) Priorität: 07.04.1987 CH 1327/87
(43) Veröffentlichungstag der Anmeldung: 12.10.1988
(73) Patentinhaber: BBC Brown Boveri AG, CH-5401 Baden (CH)
(72) Erfinder: Roggwiller, Peter, Dr., CH-8173 Riedt-Neerach (CH)

(56) Entgegenhaltungen:
- EP-A- 0 064 614
- DE-A- 2 941 021
- FR-A- 2 433 239
- PATENT ABSTRACTS OF JAPAN, Band 10, Nr. 164 (E-410)[2220], 11. Juni 1986 & JP-A-61 15 366 (MITSUO KUSANO) 23-01-1986
- IEEE ELECTRON DEVICE LETTERS, Band EDL-1, Nr. 10, Oktober 1980, Seiten 203-205, IEEE, New York, US; M. AZUMA et al.: "Anode current limiting effect of high power GTOs"

## Beschreibung

### Technisches Gebiet

Die Erfindung betrifft einen Gate-Ausschaltthyristor gemäss dem Oberbegriff des Anspruchs 1. Sie betrifft ferner ein Verfahren zu dessen Herstellung gemäss dem Oberbegriff des Anspruchs 7.

### Stand der Technik

Ueber das Gate abschaltbare Thyristoren, im folgenden kurz GTO genannt, können heute Spannungen bis 4500 V blockieren und Ströme bis 2500 A ausschalten. Solche Halbleiterstrukturen bestehen im allgemeinen aus einer grossen Anzahl integrierter, parallel geschalteter Einzelthyristoren mit pnpn-Vierschichtstrukturen. Die integrierten Einzelthyristoren verfügen über eine gemeinsame Anodenschicht, eine gemeinsame n-Basisschicht, eine gemeinsame p-Basisschicht, welche mit dem Gate in Kontakt steht, aber über getrennte Kathodenschichten. Die Kathodenschichten sind hochdotiert und wirken als n⁺-Emitter.

Ein solcher GTO wird beispielsweise in der EP-A2 0 066 850 beschrieben. Auf einem kreisrunden Halbleitersubstrat sind die integrierten Einzelthyristoren auf mehreren konzentrischen Kreisen angeordnet.

Damit hohe Ströme sicher geschaltet werden können, sind gewisse Dimensionierungskriterien, hauptsächlich im Bereich der Kathoden-und der p-Basisschicht, genau einzuhalten. Der abschaltbare Strom hängt insbesondere stark von der Querleitfähigkeit σₚ der p-Basisschicht ab.

Bei einer einfach diffundierten p-Basisschicht kann die Leitfähigkeit nur durch eine Erhöhung der Zahl der beweglichen Ladungsträger verbessert werden. Diese lässt sich nur durch eine grössere Schichtdicke oder durch eine grössere Dotierungsdichte am pn-Uebergang zwischen Kathodenschicht und p-Basisschicht erreichen. Doch beide dieser Veränderungen haben nachteilige Folgen. Eine grössere Dicke der p-Basisschicht reduziert die Verstärkung des durch n-Basisschicht, p-Basisschicht und Kathodenschicht gebildeten npn-Teiltransistors, wodurch der GTO weniger zündempfindlich und langsamer im Einschalten wird, und eine höhere Dotierungsdichte im Bereich des pn-Uebergangs zur Kathodenschicht senkt die Durchbruchspannung dieses pn-Uebergangs, sodass die Gefahr eines Lawinendurchbruchs beim Abschalten des GTO grösser wird.

Aus dem Artikel "Gate Turn-off Thyristors" Semiconductor Devices for Power Conditioning, Plenum Press, New York 1982, von M. Kurata et al. ist bekannt, dass der abschaltbare Anodenstrom proportional zunimmt zum Produkt aus Durchbruchspannung V_{BJ1} des pn-Uebergangs J₁ zwischen Kathodenschicht und p-Basisschicht mal Schichtleitwert σₚ der p-Basisschicht. Demzufolge führt eine höhere Durchbruchspannung V_{BJ1} ebenfalls zu grösseren, abschaltbaren Anodenströmen.

Bekanntermassen hängt die Durchbruchspannung eines planaren pn-Uebergangs wesentlich vom Dotierungsgradienten an dieser Stelle ab: Je grösser der Dotierungsgradient, desto kleiner ist die Durchbruchspannung. Bei einer Diffusion sind nun aber maximale Dotierungsdichte, Eindringtiefe und Dotierungsgradient voneinander abhängig. Es ist deshalb nicht möglich, auf diese Weise eine Kathodenschicht mit hoher Dotierungsdichte, d.h. guter Emitterwirkung, kleiner Eindringtiefe, wodurch sich wegen des grossen zur Verfügung stehenden Teils der p-Basisschicht eine gute Querleitfähigkeit σₚ ergibt, und einem kleinen Dotierungsgradienten am pn-Uebergang, d.h. einer hohen Durchbruchspannung, herzustellen.

Es ist nun vorgeschlagen worden (Patent Abstracts of Japan, Vol. 10, Nr. 164 (E-410) (2220), 11. Juni 1986), zur Erhöhung der Durchbruchspannung die Kathodenschicht auf den Kathodenfingern eines GTO in zwei übereinanderliegende, unterschiedlich dotierte Schichten zu unterteilen, wobei die obere, an den Kathodenkontakt grenzende Schicht wesentlich stärker, die darunterliegende, an die p-Basisschicht grenzende Schicht etwa genauso stark dotiert ist, wie die p-Basisschicht. Eine derartige Unterteilung der Kathodenschicht ist jedoch nur dann von Nutzen, wenn dabei ganz bestimmte geometrische Bedingungen eingehalten werden.

### Darstellung der Erfindung

Aufgabe der vorliegenden Erfindung ist es daher, einen Gate-Ausschaltthyristor der eingangs genannten Art so weiterzubilden, dass bei gleichbleibend guten Schaltkenngrössen des Bauelements der abschaltbare Anodenstrom zunimmt. Ferner soll eine Verfahren zur Herstellung eines erfindungsgemässen GTO angegeben werden.

Die Aufgabe wird gelöst durch die Gesamtheit der Merkmale der Ansprüche 1 und 5. Aus den Unteransprüchen ergeben sich vorteilhafte Ausführungsformen.

Durch die erfindungsgemässe Aufteilung der Kathodenschicht in eine relativ dicke, als n⁺-Emitter wirkende, hochdotierte Zone und eine relativ dünne, niedrigdotierte Zone wird trotz geringer Eindringtiefe der Kathodenschicht eine hohe Durchbruchspannung am pn-Uebergang zwischen Kathodenschicht und p-Basisschicht erreicht. Die getrennten Kathodenschichten der integrierten Einzelthyristoren des GTO sind niedrig dotiert, d.h vergleichbar mit der p-Basisschicht, und weisen nur in den Randgebieten als n⁺-Emitter wirkende, hochdotierte Zonen auf.

### Kurze Beschreibung der Zeichnungen

Nachfolgend soll die Erfindung anhand von Ausführungsbeispielen im Zusammenhang mit der Zeichnung näher erläutert werden. Es zeigen:
- Fig. 1: eine Draufsicht auf einen GTO,
- Fig. 2: einen Ausschnitt A des GTO in perspektivischer Darstellung,
- Fig. 3: eine schematische Darstellung der Dotierungsdichte des GTO entlang der in Fig. 2 gezeigten Linie B-B,
- Fig. 4: eine berechnete Dotierungsdichte für einen erfindungsgemäss hergestellten GTO,
- Fig. 5: einen Querschnitt durch einen erfindungsgemässen GTO und
- Fig. 6: eine Draufsicht auf einen erfindungsgemässen GTO mit Mesastruktur.

### Wege zur Ausführung der Erfindung

In einem Beispiel werden Aufbau und Funktion eines GTO mit Mesastruktur erläutert. Dieser Beispiel ist nicht Teil der Erfindung.

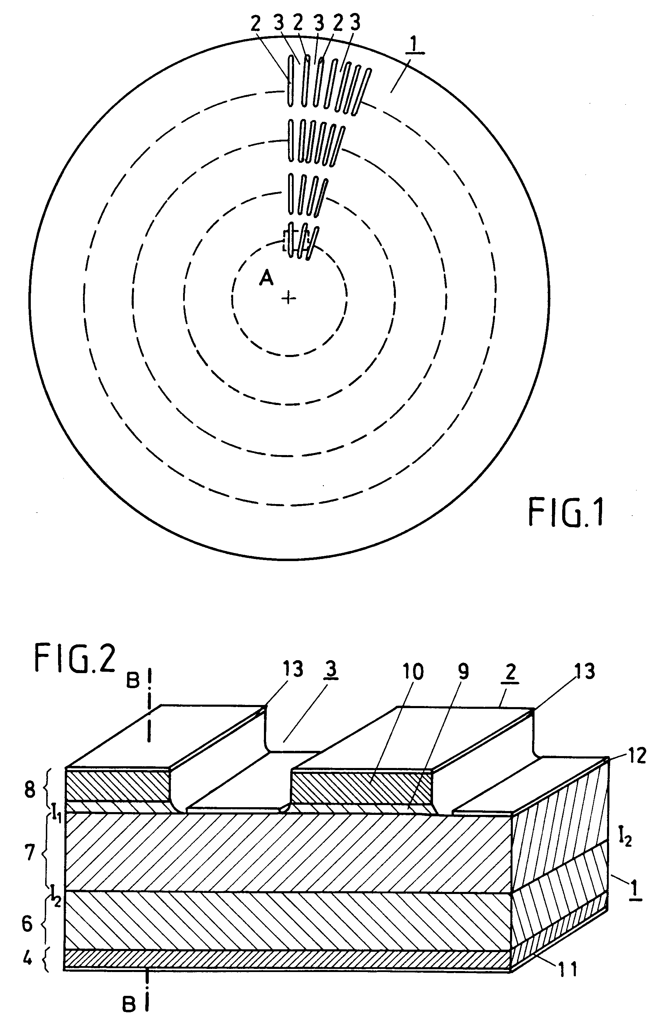

In Fig. 1 ist ein solches Bauelement dargestellt. Ein geeignet dotiertes Halbleitersubstrat 1 weist auf einer Hauptfläche eine Vielzahl von streifenförmigen Kathodenfingern 2 auf, welche auf konzentrischen Kreisen angeordnet sind. Die Kathodenfinger 2 sind durch Gräben 3 voneinander getrennt.

Fig. 2 zeigt einen Ausschnitt aus Fig. 1 in perspektivischer Darstellung. Die Kathodenfinger 2 sind mit Kathodenkontaken 13 versehen. Die Gräben 3 sind mit einer zusammenhängenden Metallschicht bedeckt, welche einen Gatekontakt 12 bildet. Auf einer zweiten Hauptfläche des Halbleitersubstrats ist eine Metallschicht als Anodenkontakt 11 aufgebracht.

Die Kathodenfinger 2, welche z.B. durch Aetzen der Oberfläche des Halbleitersubstrats 1 erzeugt werden können, haben eine Breite von einigen 100 µm und eine Länge von einigen mm. Die Gräben 3 haben eine Tiefe von etwa 10-40 µm.

In seinem Inneren hat das Halbleitersubstrat 1 eine pnpn-Vierschichtstruktur. Eine n-leitende Kathodenschicht 8 liegt direkt unter dem Kathodenkontakt 13. Eine p-Basisschicht 7 schliesst an die Kathodenschicht 8 an und bildet mit ihr einen ersten pn-Uebergang J₁. Die p-Basisschicht 7 tritt in den Gräben 2 an die Oberfläche des Halbleitersubstrats 1, so dass sie über den bereits beschriebenen Gatekontakt 12 angesteuert werden kann. Unter der p-Basisschicht 7 liegt eine n-Basisschicht 6. Dadurch entsteht ein zweiter pn-Uebergang J₂. Zwischen der n-Basisschicht 6 und dem Anodenkontakt 11 liegt eine p-leitende Anodenschicht 4.

Um die Zeichnung übersichtlicher zu gestalten, sind in Fig. 2 Schichten gleichen Leitungstyps mit gleichgerichteter Schraffur versehen. Eine dichte Schraffur soll eine hohe Dotierungsdichte andeuten, eine schwache Schraffur eine geringe Dotierungsdichte.

Die Kathodenschicht 8 ist in eine hochdotierte Zone 10 und eine relativ dazu niedrigdotierte Zone 9 aufgeteilt. Die hochdotierte Zone 10 grenzt an die kathodenseitige Oberfläche des Halbleitersubstrats 1 und reicht bis kurz vor den pn-Uebergang J₁. Die niedrigdotierte Zone 9 erstreckt sich vom pn-Uebergang J₁ bis zur hochdotierten Zone 10.

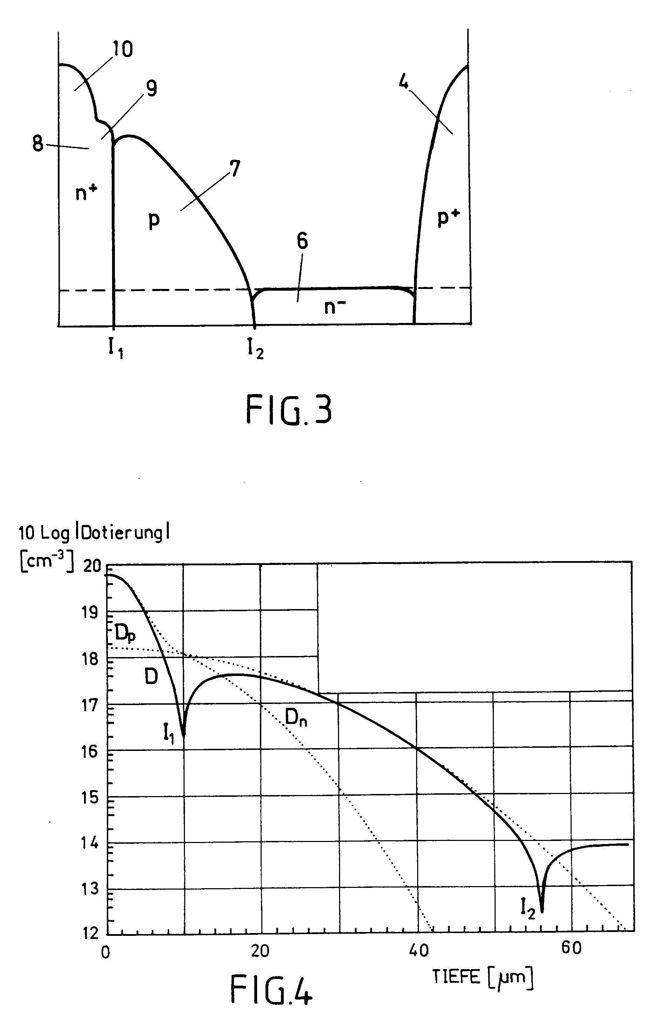

In Fig. 3 ist eine schematische Darstellung der Dotierungsdichte entlang der in Fig. 2 eingezeichneten Linie BB gezeigt. Darin sind die Kathodenschicht 8 mit der niedrigdotierten Zone 9 und der hochdotierten Zone 10, die p-Basisschicht 7, die n-Basisschicht 6 und die Anodenschicht 4 zu erkennen.

Die Dotierungsdichte der n-Basisschicht 6 entspricht der Grunddotierung des Halbleitersubstrats, welche bevorzugterweise zwischen 10¹³ und 10¹⁴ cm⁻³ liegt. Die p-leitende Anodenschicht 4 ist hochdotiert und wirkt als p⁺-Emitter. Um einen optimalen ohmschen Kontakt zum Anodenkontakt 11 zu erhalten, liegt die Dotierungsdichte dieser Schicht an der Oberfläche des Halbleitersubstrats vorzugsweise zwischen 10¹⁵ und 10²⁰ cm⁻³. Nach Wunsch kann die Anodenschicht 4 n⁺-Kurzschlüsse aufweisen. Die p-Basisschicht 7 hat am pn-Uebergang J₁ eine Dotierungsdichte von vorzugsweise etwa 10¹⁸ cm⁻³.

Die Kathodenschicht 8 ist wie bereits erwähnt in zwei Zonen aufgeteilt. Die hochdotierte Zone 10 hat die Aufgabe, als n⁺-Emitter zu wirken. Deshalb soll ihre Dotierungsdichte um mindestens eine Grössenordnung höher sein als diejenige der p-Basisschicht 7. Um nun entsprechend der Erfindung die Durchbruchspannung V_{BJ1} des pn-Uebergangs J₁ zu erhöhen ist die zweite, niedrigdotierte Zone 9 vorgesehen, deren Dotierungsdichte vergleichbar sein soll mit derjenigen der p-Basisschicht 7, beispielsweise etwa 10¹⁵ cm⁻³. Die Aufgabe dieser niedrigdotierten Zone 9 liegt darin, am pn-Uebergang J₁ einen kleinereren Dotierungsgradienten zu schaffen und die Raumladungszone, welche in die Kathodenschicht 8 eindringt, aufzunehmen. Da bei einem pn-Uebergang, wie er soeben beschrieben worden ist, pro µm eine Spannung von ca. 20 V abgebaut wird, liegt die Dicke der niedrigdotierten Zone 9 vorzugsweise bei 2-4 µm. Ist sie dünner, so ist ihre Wirkung verloren, ist sie dicker, so wirkt sie sich negativ auf die Effizienz der als n⁺-Emitter arbeitenden, hochdotierten Zone 10 aus.

Die Dotierungsdichte der hochdotierten Zone 10 beträgt vorzugsweise mehr 10¹⁹ cm⁻³. Auf diese Weise ist gleichzeitig ein guter ohmscher Kontakt zum Kathodenkontakt 13 gewährleistet.

Die hochdotierte Zone 10 ist so bemessen bezüglich Dicke und Dotierungsdichte, dass die Schichteigenschaften, wie Widerstand und Emitterwirkungsgrad, der Kathodenschicht 8 durch sie bestimmt sind. Die niedrigdotierte Zone 9 bildet ein Attribut zur Kathodenschicht 8, welches sich nur auf die Durchbruchspannung des pn-Uebergangs J₁ auswirken soll.

Für einen solchen, erfindungsgemässen GTO ergibt sich der Vorteil, bei sonst gleichbleibend guten Schaltkenngrössen grössere Anodenströme schalten zu können.

In einem Ausführungsbeispiel soll eine Ausgestaltung der Erfindung beschrieben werden.

Wiederum wird von einem GTO mit Mesastruktur ausgegangen.

In der äusseren Form unterscheidet sich dieses Ausführungsbeispiel nicht vom Beispiel nach Fig. 1-3. Der Hinweis auf Fig. 1 möge deshalb eine wiederholte Beschreibung der äusseren Elemente ersetzen.

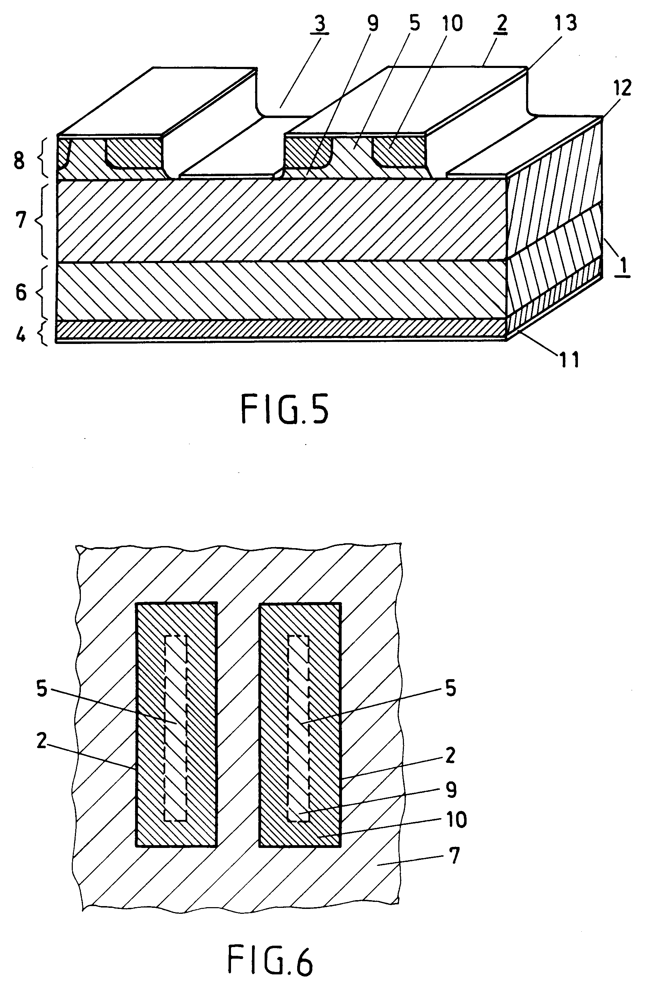

Fig. 5 zeigt in perspektivischer Darstellung einen Ausschnitt aus dem zweiten Ausführungsbeispiel. Anodenschicht 4, n-Basisschicht 6 und p-Basisschicht 7 haben die selben Dicken und Dotierungsdichten wie im zuvor beschriebenen Beispiel.

Neu ist die Ausgestaltung der Kathodenschicht 8. Die niedrigdotierte Zone 9 hat hier nicht eine konstante Dicke von wenigen µm, sondern sie dehnt sich in gewünschten Bereichen, insbesondere in einem Mittelstreifen 5, bis zum Kathodenkontakt 13 aus. Auf diese Weise wird die als n⁺-Emitter wirkende, hochdotierte Zone 10 seitlich begrenzt.

In Fig. 6 sind in der Draufsicht zwei Kathodenfinger 2 dargestellt. Mit der Schraffur ist die Dotierung der unter der Oberfläche des Halbleitersubstrats liegenden Schicht angedeutet, wobei mit gleichgerichteter Schraffur gleicher Leitungstyp und mit der Schraffurdichte die Dotierungsdichte angedeutet wird.

Es ist zu erkennnen, dass die Kathodenfinger 2 nur am Rand eine als Emitter wirkende, hochdotierte Zone 10 besitzen. Im Mittelstreifen 5 reicht die niedrigdotierte Zone 9 vom pn-Uebergang J₁ bis hin zur Oberfläche.

Daraus ergibt sich eine vorteilhafte Wirkung beim Ausschalten des GTO.

Erstreckt sich nämlich die hochdotierte Zone 10 über den ganzen Kathodenfinger 2, so kommt es beim Ausschalten zu einer Stromfokussierung im Mittelstreifen 5 des Kathodenfingers 2, welche bedingt ist durch das Einschnüren des leitenden Teils des pn-Uebergangs J₁. Die damit auftretenden, hohen Stromdichten können das Bauelement lokal thermisch zerstören.

Mit dem der Erfindung entsprechenden GTO wird diese Stromfokussierung entschärft, da der Hauptteil des Anodenstroms in den Randgebieten der Kathodenfinger 2 fliesst und somit im Endstadium des Abschaltens, also kurz vor dem Abschnüren gar keine relevanten Ströme mehr unterbunden werden müssen.

Zur Erfindung gehört auch ein Verfahren zur Herstellung eines erfindungsgemässen Bauelements.

Dieses Verfahren zeichnet sich dadurch aus, dass die Kathodenschicht 8 durch zwei Diffusionsschritte erzeugt wird. Auf diese Weise erhält man bei der Erzeugung des Dotierungsprofils der Kathodenschicht 8 einen zusätzlichen Freiheitsgrad, sodass es möglich wird, sowohl Dotierungsdichte an der Oberfläche des Halbleitersubstrats und Eindringtiefe der Schicht als auch Dotierungsgradient am pn-Uebergang J₁ unabhängig von einander zu wählen.

Ausgangspunkt ist ein Halbleitersubstrat mit einer gewünschten Grunddotierung. Auf einer, für den Kathodenkontakt vorgesehen Hauptfläche des Halbleitersubstrats wird eine Prädeposition von Dotierstoff zur Erzeugung einer p-Basisschicht vorgenommen. In einem nachfolgenden Diffusionsschritt wird die p-Dotierung eingetrieben, allerdings noch nicht bis zur endgültigen Eindringtiefe der p-Basisschicht.

Zur Erzeugung der n-leitenden Kathodenschicht wird zweimal prädeponiert und zweimal diffundiert.

Für eine niedrigdotierte Zone einer Kathodenschicht 8 wird eine Prädeposition mit einer ähnlichen Oberflächenbelegung wie bei der p-Basisschicht gewählt. Beim nachfolgenden Diffusionsschritt wird der pn-Uebergang zwischen Kathodenschicht 8 und p-Basisschicht 7 in die vorgesehenen Tiefe eingetrieben. Die hochdotierte Zone 10 der Kathodenschicht 8 wird so diffundiert, dass die bereits entstandenen pn-Uebergänge nicht mehr verändert werden. Eine hohe Oberflächenkonzentration wird bei einer niedrigeren Temperatur als derjenigen der vorhergehenden Diffusionsschritte während verhältnismässig kurzer Zeit eingetrieben.

Als Ausführungsbeispiel soll nachfolgend die erfindungsgemässe Herstellung eines GTO mit Mesastruktur erläutert werden.

Ausgangspunkt des Ausführungsbeispiels ist ein Halbleitersubstrat mit einer Grunddotierung von etwa 8·10¹³ cm⁻³. Eine für den Kathodenkontakt vorgesehenen Hauptfläche des Halbleitersubstrats wird mit einer Borbelegung von 5.0·10¹⁵ cm⁻² versehen. Danach wird das Bor während 42 Stunden bei 1250 °C eingetrieben, was eine provisorische p-Basisschicht erzeugt. Die Kathodenschicht wird erfindungsgemäss in zwei Schritten diffundiert. In einem ersten Schritt wird eine Phosphorbelegung von etwa 5.0·10¹⁵ cm⁻² während 14 Stunden bei 1250 °C eingetrieben. Bei dieser Diffusions wird zugleich noch die provisorische p-Basisschicht bis zur gewünschten, endgültigen Eindringtiefe getrieben. In einem zweiten Schritt wird eine Phosphorbelegung von etwa 4.0·10¹⁶ cm⁻³ während vier Stunden bei 1200 °C eindiffundiert. Dabei erzeugt die erste Diffusion die niedrigdotierte und die zweite die hochdotierte Zone der Kathodenschicht. Wegen der niedrigeren Temperatur der zweiten Diffusion wird die p-Basisschicht bei diesem Schritt nicht mehr verändert.

In Fig. 4 ist der Verlauf einer entsprechend dem erfindungsgemässen Verfahren berechneten Dotierungsdichte gezeigt. Die durchgezogene Kurve D entspricht der endgültigen Dotierungsdichte und die punktierten Linien Dₚ resp. Dₙ stellen die Dotierungsdichten der p- resp. der n-Störstellen dar.

Das Ausführungsbeispiel führt auf ein Bauelement mit einem pn-Uebergang J₁ zwischen Kathodenschicht und p-Basisschicht in einer Tiefe von etwa 10 µm und einem pn-Uebergang J₂ zwischen p-Basisschicht und n-Basisschicht in einer Tiefe von etwa 56 µm. In Fig. 4 ist bei der punktierten Kurve Dₙ ein erfindungsgemässes Abflachen etwa 2-3 µm vor dem pn-Uebergang J₁ zu erkennen, was sich positiv auf die Durchbruchspannung U_{BJ1} des pn-Uebergang auswirkt. Aus der Rechnung ergab sich eine Durchbruchspannung V_{BJ1} von 31.38 V bei einem Schichtwiderstand der p-Basisschicht von 59.58 Ohm/sq. Ein vergleichbares Bauelement, gerechnet entsprechend dem Stand der Technik, hat, bei etwa gleich tiefen pn-Uebergängen, ähnlicher Dotierungsdichte an der Oberfläche des Halbleitersubstrats und ähnlichem Schichtleitwert der p-Basisschicht, nur eine etwa halb so grosse Durchbruchspannung V_{BJ1}.

Das auf die oben beschriebene Weise dotierte Halbleitersubstrat, in welches auch in bekannter Art eine nicht näher erläuterte Anodenschicht eingebracht worden ist, wird mit ebenfalls bekannten Verfahren zu einem mesastrukturierten GTO weiterverarbeitet.

Entsprechend der Erfindung wird die Oberflächenbelegung, welcher zur Erzeugung der als Emitter wirkenden, hochdotierten Zone der Kathodenschicht dient, strukturiert, derart, dass nach der Diffusion dieser Oberflächenbelegung sich die niedrigdotierte Zone der Kathodenschicht in gewissen Gebieten, insbesondere in einem Mittelstreifen der Kathodenfinger 2 von mesastrukturierten GTO, vom pn-Uebergang, J₁ bis hin zur Oberfläche des Halbleitersubstrats erstreckt.

Abschliessend kann gesagt werden, dass mit der Erfindung ein Gate-Ausschaltthyristor zur Verfügung steht, welcher bei sonst gleichbleibend guten Eigenschaften grössere Anodenströme schalten und auf einfache Weise hergestellt werden kann.

## Patentansprüche

1. Gate-Ausschaltthyristor (GTO) mit Mesastruktur umfassend ein Halbleitersubstrat (1) mit mindestens
a) einer p-leitenden Anodenschicht (4);
b) einer n-Basisschicht (6);
c) einer p-Basisschicht (7), welche in elektrischem Kontakt mit einem Gate steht;
d) einer n-leitenden Kathodenschicht (8), welche durch Gräben (3) in eine Vielzahl von einzelnen Kathodenfingern (2) aufgeteilt ist; wobei
e) die Kathodenschicht (8) eine als n⁺-Emitter wirkende hochdotierte Zone (10) aufweist, welche an eine Oberfläche des Halbleitersubstrats (1) grenzt und eine um mindestens eine Grössenordnung höhere Dotierungsdichte hat als die p-Basisschicht (7); und wobei
f) in der Kathodenschicht (8) zwischen der hochdotierten Zone (10) und dem durch die Kathodenschicht (8) und die p-Basisschicht (7) gebildeten pn-Uebergang (J₁) eine niedrigdotierte Zone (9) vorgesehen ist, welche eine Dotierungsdichte hat, die vergleichbar mit derjenigen der p-Basisschicht (7) am pn-Uebergang zur Kathodenschicht (8) ist;
dadurch gekennzeichnet, dass
g) die niedrigdotierte Zone (9) der Kathodenschicht (8) in einem Mittelstreifen (5) der Kathodenfinger (2) vom pn-Uebergang bis zur Oberfläche des Halbleitersubstrats (1) reicht;
h) die als n⁺-Emitter wirkende, hochdotierte Zone (10) nur am Rand der Kathodenfinger (2) vorhanden ist;
i) die hochdotierte Zone (10) die niedrigdotierte Zone (9) im Mittelstreifen vollständig umgibt;
j) die hochdotierte Zone (10) bis kurz vor den pn-Uebergang (J₁) reicht; und
k) die niedrigdotierte Zone (9) im Bereich, wo sie die p-Basisschicht (7) von der hochdotierten Zone (10) trennt, ein Dicke von wenigen µm aufweist.

2. Gate-Ausschaltthyristor nach Anspruch 1, dadurch gekennzeichnet, dass die niedrigdotierte Zone (9) im Bereich, wo sie die p-Basisschicht (7) von der hochdotierten Zone (10) trennt, ein Dicke von 2-4 µm aufweist.

3. Gate-Ausschaltthyristor nach Anspruch 2, dadurch gekennzeichnet, dass die Dicke der p-Basisschicht (7) etwa 45 µm und diejenige der Kathodenschicht (8) etwa 10 µm beträgt.

4. Gate-Ausschaltthyristor nach Anspruch 3, dadurch gekennzeichnet, dass
a) die maximale Dotierungsdichte der hochdotierten Zone (10) der Kathodenschicht (8) mehr als 10¹⁹ cm⁻³ beträgt,
b) die Dotierungsdichte der niedrigdotierten Zone (9) der Kathodenschicht (8) etwa 10¹⁸ cm⁻³ beträgt,
c) die Dotierungsdichte der p-Basisschicht (7) am pn-Uebergang zur Kathodenschicht (8) etwa 10¹⁸ cm⁻³ und
d) die Dotierungsdichte der n-Basisschicht 10¹³ cm⁻³ beträgt.

5. Verfahren zur Herstellung eines Gate-Ausschaltthyristors nach Anspruch 1, bei welchem Verfahren das Dotierungsprofil der Kathodenschicht (8) in zwei Diffusionsschritten erzeugt wird, wobei beim ersten Diffusionsschritt die Tiefe und die Durchbruchseigenschaften des pn-Uebergangs (J₁) zwischen der Kathodenschicht (8) und der p-Basisschicht (7) und beim zweiten Schritt die Schichteigenschaften der Kathodenschicht (8) selbst festgelegt werden, ohne dass die Lage und Eigenschaften der vorher erzeugten Uebergänge im Halbleitersubstrat (1) verändert werden, dadurch gekennzeichnet, dass
a) zur Erzeugung der n-Basisschicht (6) eine Borbelegung von etwa 5.10¹⁵ cm⁻² während etwa 42 Stunden bei 1250 °C eindiffundiert wird;
b) zur Erzeugung der niedrigdotierten Zone (9) der Kathodenschicht (8) eine Phosphorbelegung von etwa 5.10¹⁵ cm⁻² während 14 Stunden bei 1250 °C eindiffundiert wird; und
c) nachträglich zur Erzeugung der hochdotierten Zone (10) der Kathodenschicht (8) eine Phosphorbelegung von etwa 4.10¹⁶ cm⁻² während vier Stunden bei 1200 °C eindiffundiert wird, wobei die Belegung selektiv am Rand der einzelnen Kathodenfinger (2) erfolgt.

## Claims

1. Gate turn-off thyristor (GTO) having mesa structure comprising a semi-conductor substrate (1) with at least
a) one p-conducting anode layer (4);
b) one n-type base layer (6);
c) one p-type base layer (7), which is in electrical contact with a gate;
d) one n-conducting cathode layer (8), one n-conducting cathode layer (8) which is divided up into a multiplicity of individual cathode fingers (2) by trenches (3); in which
e) the cathode layer (8) has a highly doped zone (10) which acts as n⁺ emitter and adjoins a surface of the semi-conductor substrate (1) and has a doping density at least an order of magnitude higher than the p-type base layer (7); and in which
f) a lightly doped zone (9) is provided in the cathode layer (8) between the highly doped zone (10) and the pn junction (J₁) formed by the cathode layer (8) and the p-type base layer (7), which has a doping density which is comparable to that of the p-type base layer (7) at the pn junction to the cathode layer (8),
characterised in that
g) the lightly doped zone (9) of the cathode layer (8) extends in a central strip (5) of the cathode finger (2) from the pn junction to the surface of the semi-conductor substrate (1);
h) the highly doped zone (10) which acts as n⁺-type emitter is present only at the periphery of the cathode fingers (2);
i) the highly doped zone (10) completely surrounds the lightly doped zone (9) in the central strip;
j) the highly doped zone (10) extends up to just in front of the pn junction (J₁); and
k) the lightly doped zone (9) has a thickness of a few µm in the region where it separates the p-type base layer (7) from the highly doped zone (10).

2. Gate turn-off thyristor according to Claim 1, characterised in that the lightly doped zone (9) has a thickness of 2-4 µm in the area where it separates the p-type base layer (7) from the highly doped zone (10).

3. Gate turn-off thyristor according to Claim 2, characterised in that the thickness of the p-type base layer (7) is about 45 µm and that of the cathode layer (8) is about 10 µm.

4. Gate turn-off thyristor according to Claim 3, characterised in that
a) the maximum doping density of the highly doped zone (10) of the cathode layer (8) exceeds 10¹⁹cm⁻³,
b) the doping density of the lightly doped zone (9) of the cathode layer (8) is about 10¹⁸cm⁻³,
c) the doping density of the p-type base layer (7) is about 10¹⁸cm⁻³ at the pn junction to the cathode layer (8) and
d) the doping density of the n-type base layer is 10¹³cm⁻³.

5. Method for producing a gate turn-off thyristor according to Claim 1, in which method the doping profile of the cathode layer (8) is produced in two diffusion steps, the depth and the breakdown properties of the pn junction (J₁) between the cathode layer (8) and the p-type base layer (7) being determined in the first diffusion step and the layer properties of the cathode layer (8) itself being self-determined in the second step, without the position and properties of the junctions previously produced in the semi-conductor substrate (1) being altered, characterised in that
a) to produce the n-type base layer (6), a boron coverage of about 5x10¹⁵cm⁻² is diffused in for about 42 hours at 1250°C;
b) to produce the lightly doped zone (9) of the cathode layer (8), a phosphorus coverage of about 5x10¹⁵cm⁻² is diffused in for 14 hours at 1250°C; and
c) subsequent to the production of the highly doped zone (10) of the cathode layer (8), a phosphorus coverage of about 4x10¹⁶cm⁻² is diffused in for four hours at 1200°C, the coverage taking place selectively at the periphery of the individual cathode fingers (2).

## Revendications

1. Thyristor à blocage par la gâchette (GTO) à structure mésa comprenant un substrat semi-conducteur (1) avec au moins :
a) une couche d'anode de conductivité P (4);
b) une couche de base N (6);
c) une couche de base P (7) qui est en contact électrique avec une gâchette;
d) une couche d'anode de conductivité N (8) qui est subdivisée par des fosses (3) en une pluralité de doigts de cathode individuels (2);
de sorte que
e) la couche de cathode (8) présente une zone fortement dopée (10) opérant comme émetteur N⁺, qui est contiguë à une surface du substrat semi-conducteur (1) et présente une densité de dopage supérieure d'au moins un ordre de grandeur à celle de la couche de base P (7);
et de sorte que
f) dans la couche de cathode (8), entre la zone fortement dopée (10) et la jonction PN (J₁) formée par la couche de cathode (8) et la couche de base P (7), est prévue une zone faiblement dopée (9) qui présente une densité de dopage comparable à celle de la couche de base (7) à la jonction PN vers la couche de cathode (8);
caractérisé en ce que :
g) la zone faiblement dopée (9) de la couche de cathode (8) s'étend dans une bande médiane (5) du doigt de cathode (2) depuis la jonction PN jusqu'à la surface du substrat semi-conducteur (1);
h) la zone fortement dopée (10) opérant comme émetteur N⁺ n'est présente qu'au bord du doigt de cathode (2);
i) la zone fortement dopée (10) entoure complètement la zone faiblement dopée (9) dans la bande médiane;
j) la zone fortement dopée (10) s'étend jusqu'à une courte distance devant la jonction PN (J₁), et
k) la zone faiblement dopée (9) présente, dans la région où elle sépare la couche de base P (7) de la zone fortement dopée (10), une épaisseur de quelques µm.

2. Thyristor à blocage par la gâchette suivant la revendication 1, caractérisé en ce que la zone faiblement dopée (9) présente, dans la région où elle sépare la couche de base P (7) de la zone fortement dopée (10), une épaisseur de 2 à 4 µm.

3. Thyristor à blocage par la gâchette suivant la revendication 2, caractérisé en ce que l'épaisseur de la couche de base P (7) est d'environ 45 µm et celle de la couche de cathode (8) d'environ 10 µm.

4. Thyristor à blocage par la gâchette suivant la revendication 3, caractérisé en ce que :
a) la densité de dopage maximale de la zone fortement dopée (10) de la couche de cathode (8) est supérieure à 10¹⁹ cm⁻³;
b) la densité de dopage de la zone faiblement dopée (9) de la couche de cathode (8) est d'environ 10¹⁸ cm⁻³;
c) la densité de dopage de la couche de base (7) au niveau de la jonction PN vers la couche de cathode (8) est d'environ 10¹⁸ cm⁻³, et
d) la densité de dopage de la couche de base N est de 10¹³ cm⁻³.

5. Procédé de fabrication d'un transistor à blocage par la gâchette suivant la revendication 1, dans lequel le profil de dopage de la couche de cathode (8) est créé en deux opérations de diffusion, étant entendu que, dans la première opération de diffusion, la profondeur et les propriétés de claquage de la jonction PN (J₁) entre la couche de cathode (8) et la couche de base P (7) et que, dans la seconde opération, les propriétés de couche de la couche de cathode (8) elle-même sont établies, sans que la position et les propriétés des jonctions précédemment créées dans le substrat semi-conducteur (1) soient modifiées, caractérisé en ce que :
a) pour produire la couche de base N (6), on incorpore par diffusion un revêtement de bore d'environ 5x10¹⁵ cm⁻² pendant environ quarante-deux heures à 1250°C;
b) pour produire la zone faiblement dopée (9) de la couche de cathode (8), on incorpore par diffusion un revêtement de phosphore d'environ 5x10¹⁵ cm⁻² pendant quatorze heures à 1250°C, et
c) après avoir créé la zone fortement dopée (10) de la couche de cathode (8), on incorpore par diffusion un revêtement de phosphore d'environ 4x10¹⁶ cm⁻² pendant quatre heures à 1200°C, le revêtement s'effectuant sélectivement au bord des doigts de cathode individuels (2).
